# EUROPEAN PATENT SPECIFICATION

(11) **EP 1 211 918 B1**
(45) Date of publication and mention of the grant of the patent: **12.07.2006**
(21) Application number: 01830644.9
(22) Date of filing: 11.10.2001
(51) Int. Cl.: H05G 2/00

(54) **Method of stopping ions and small debris in extreme-ultraviolet and soft x-rays plasma sources by using krypton**
Methode zum Stoppen von Ionen und Verunreinigungen in Plasma-Strahlungquellen im extremem-ultaviolett oder weichen Röntgenbereich durch Verwendung von Krypton
Procédé d'arrêt des ions et des débris de petite taille dans des sources à plasma d'ultraviolet extrême et des rayons X faibles, par l'utilisation du krypton

(30) Priority: 01.12.2000 IT RM000636
(43) Date of publication of application: 05.06.2002
(73) Proprietor: ENEA ENTE PER LE NUOVE TECNOLOGIE, L'ENERGIA E L'AMBIENTE, 00196 Roma (IT)
(72) Inventor: Flora, Francesco, 00040 Montecompatri (RM) (IT); Zheng, Chengen, 00172 Roma (IT); Mezi, Luca, 00046 Grottaferrata (RM) (IT)
(74) Representative: Sarpi, Maurizio

(56) References cited:
- WO-A-01/31678
- WO-A-99/42904
- US-A- 4 408 338
- US-A- 4 692 934
- BIJKERK F ET AL: "LASER PLASMA SOURCES FOR SOFT X-RAY PROJECTION LITHOGRAPHY" JOURNAL DE PHYSIQUE III, EDITIONS DE PHYSIQUE, PARIS, FR, vol. 4, no. 9, 1 September 1994 (1994-09-01), pages 1669-1677, XP000468498 ISSN: 1155-4320

## Description

The present invention mainly relates to the projection microlithography with Extreme-Ultra-Violet (EUV) and particularly the problems relative to duration and cost of the optical apparatus used in such applications. However, it should be noted that the field of application of the invention is an improvement of the radiation source and then extends to all of the possible applications of EUV and soft X-ray sources emitting debris or unwanted polluting fragments.

The industrial interests toward microlithography with soft X-rays mainly originate from that the density of the electronic components on a microchip depends more than by geometric ratio on the space resolution by which the microchip is manufactured, and (consequently) on the wavelength of the radiation used by the apparatus for the projection of the circuits onto the silicon wafers.

As a result, the scientific, industrial interest for the radiation sources in the EUV and in the soft X-ray spectral regions is highly increased in recent years. Particularly in the field of microelectronics and nanomechanics the use of sources of EUV and soft X-rays allows space resolutions lower than 100 nm to be reached, i.e. far lower than those presently reached in microelectronics Companies by using ultraviolet light or radiation of excimer laser (ArF laser with a wavelength of 193 nm).

A great project involving several research centres (Sandia National Laboratory, Lawrence Livermoore National Laboratory, Berkeley National Laboratory) and several microelectronics Companies (INTEL, MOTOROLA, AMD, INFINEON, MICRON) is being developed in U.S.A. for manufacturing a first prototype of a projection microlithography apparatus in the EUV range within 2005, i.e. the range with the lowest energy regarding soft X-rays (namely a wavelength of 13.4 nm, at which the best multilayer mirrors for EUV can be produced at the time being). This apparatus is based on a laser-plasma source with high average power (a 1.7 kW laser) which uses xenon vapours as target: the laser brings xenon to the state of plasma (at about 1 million degrees) and the latter emits EUV radiation that is received by a mirror and then used to project the pattern of suitable masks onto a silicon wafer. The high absorption that all materials have in the EUV range forces to the exclusive use of reflection optics (i.e. multilayer mirrors).

Two further similar projects are being developed in France and Germany by using both plasma produced in gases and plasma produced on solid targets.

The latter type of source allows the highest efficiency to be reached, however, it is suffering from a serious problem: plasma emits not only EUV radiation but also debris (drops of molten metal at very high speed) as well as ions and neutrals that hit the first mirror of the optical projection system and damage it in a short time, thus making its replacement necessary.

This involves a considerable productivity slowdown as well as a great rise in costs as such mirrors are very expensive.

The present invention seeks to overcome the above problems and drawbacks by providing a method and the relative device able to stop ions and small debris emitted by an EUV radiation plasma source in order to avoid the damages caused by the same to the first mirror of the focusing optics of the microlithography apparatus and the like.

The specific physical characteristics of the noble gas krypton make it able to "filter" the ions and small debris (with a size lower than few microns) emitted by the plasma source and at the same time to transmit a considerable proportion of EUV radiation (for example 80% for a product pressure-by-distance of 10 mbar*cm).

Using a flow of Krypton to protect mirrors from debris is known from Bijkevk et. al. Journal de Physique III, Vol. 4 pg. 1669-1677 (1994). It is an object of the present invention to provide a method of filtering the above-mentioned ions and small debris according to claim 1 as well as a device for carrying out such method.

Such novel filtration method combined, if necessary, with already tested, improved mechanical methods of filtration of debris with large size (greater than one micron) allows plasma EUV radiation without polluting debris to be obtained and, for example, the useful life of the expensive mirrors of a microlithography apparatus to be greatly extended.

These and other purposes of the invention will be more readily apparent from the following detailed description with reference to the accompanying drawings that show some preferred embodiments thereof only by way of a not limiting example.

In the drawings:
Fig. 1 is a diagram showing the transmission of krypton and helium at the pressure of 1 mbar over a distance of 10 cm according to data of Henke;
Fig. 2 shows the results of a simplified calculation model for the depth of penetration of the tantalum ions with energy equal to 4.6 keV (continuous curves) or 0.8 keV (dotted curves) flying in helium and krypton vs the gas pressure;
Figs. 3A-3C show pictures (in transmission) of plastic film (3x3 mm²) exposed to bombardment of tantalum ions at a distance of 4 cm from the source with 400 laser pulses under vacuum, in helium at 1.2 mbar, in krypton at 2.5 mbar, respectively;
Fig. 3D shows the non-exposed film by comparison;
Figs. 4A and 4B are pictures of tantalum debris (clear dots) deposited on the films of Figs. 3A and 3C, respectively, and observed through an optical microscope (40X) in the reflection mode (the width of the visual field is 400 µm x 270 µm) ;
Figs. 5A and 5B show diagrams of the peak value of the EUV signals of 50-70 eV transmitted through a 1.6 µm thick aluminium foil placed at a distance of 5 cm from the source (on the perpendicular to the target) during 100 shots, under vacuum and in krypton at 2.5 mbar, respectively;
Fig. 6 shows schematically a device for EUV microlithography in which the chamber of the source is filled with krypton under low pressure according to the invention;
Fig. 7 shows a first variation of the diagram of Fig. 6 including a schematic ventilation system with a ventilator able to generate a transverse flow of krypton and a filter to keep it clean;
Fig. 8 shows a second variation of the diagram of Fig. 6 including one or more rotating perforated disks (or shutters) to stop the slow debris and the metal cloud, produced by the plasma in Kr, as well;
Fig. 9 shows a third variation of the diagram of Fig. 6 including the two preceding variations.

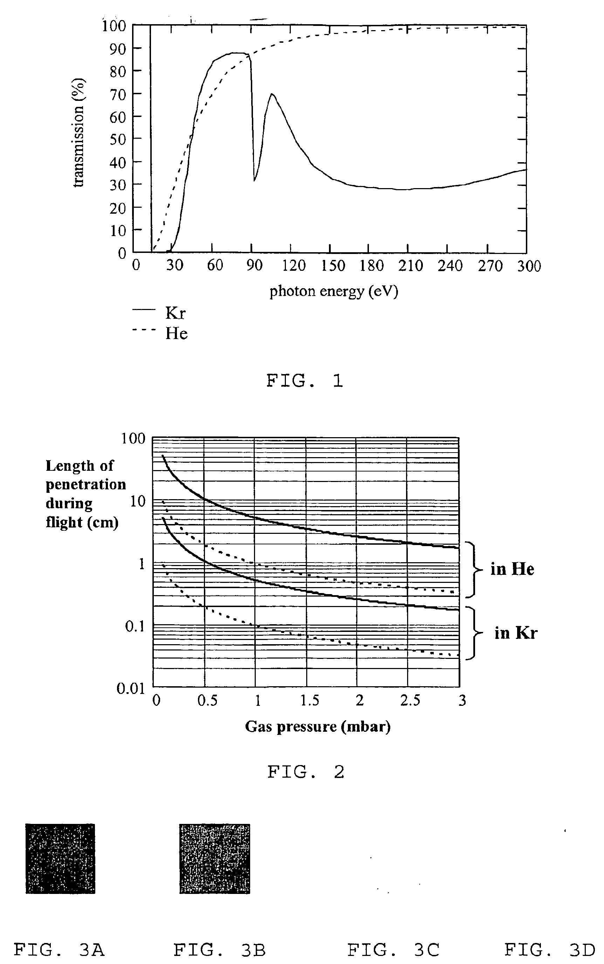

It is known that krypton has an EUV transmission window between 60 and 90 eV, as shown in Fig. 1.

This spectrum range is very important for the applications of an EUV radiation to projection microlithography apparatus because mirrors with high reflectivity (70% at 88-92 eV or at a wavelength of 13.4-14.2 nm) which are indispensable to reproduce the mask pattern on silicon wafer can only be manufactured in such range.

As known, helium is the gas most transparent to soft X-rays but its use to stop ions or small debris is drastically limited by its low atomic mass. Krypton has instead a 21 time greater atomic mass, even if it has a transparency which is similar to helium in the above-mentioned range, thus obtaining a greater efficiency in stopping ions or small debris.

Fig. 2 shows a diagram of the results of a theoretical calculation (in the simplified assumption of only elastic collisions) regarding the flight range of tantalum atom ions in helium and krypton. The results of such calculations are that ions are stopped in krypton in a ten times shorter spatial range than in helium.

The reason why tantalum ions are used is that, during experimentations, a higher EUV-radiation production efficiency and a lower debris emission have been observed from a tantalum target. In any case, similar results would be achieved by any target material.

In order to have a first qualitative confirmation about the correctness of such statement, transparent plastic films have been exposed to the bombardment of tantalum ions (400 shots) emitted by the laser-plasma source, i.e. a source based on a tantalum tape target heated to the state of plasma by a XeCl excimer laser emitting pulses with 4 J energy and 120 ns duration at a wavelength of 308 nm.

As can be seen in Figs. 3A-3D, the latter showing a non-exposed film, the deposit of ions reduces the transparency of the exposed film under vacuum (Fig. 3A) and in helium (Fig. 3B) but said reduction is much less in krypton (Fig. 3C). Upon observing these films by optical microscope in reflection mode, the tantalum debris can be easily recognized as they are bright under the light of the microscope.

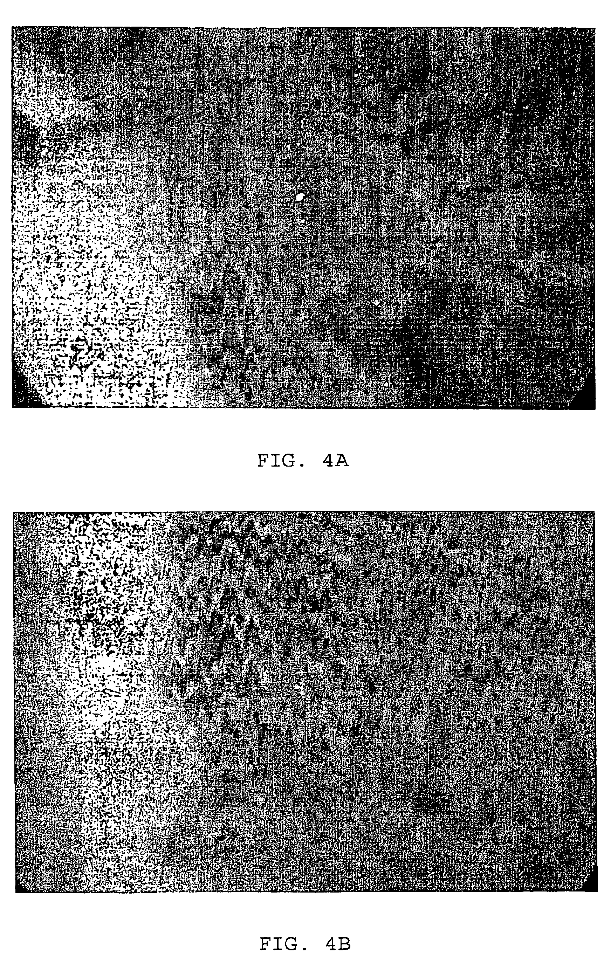

Referring to Figs. 4A and 4B corresponding to the above Figs. 3A and 3C, it should be noted that also debris are advantageously filtered together with ions in the film exposed in krypton (Fig. 4B). In fact, on most of the examined zones no debris could be observed. This advantageous result has been achieved although there are a great number of debris as can be seen from Fig. 4A relative to the film exposed in the vacuum.

In order to have a more quantitative confirmation of the Kr effect on ions, the high absorption of tantalum in EUV has been used (the characteristic length of penetration at 70 eV is only 12 nm). In this experiment, an aluminium foil with a thickness of 1.6 µm placed at 5 cm from the tantalum laser-plasma source was exposed to the bombardment and the flux of EUV radiation transmitted through the foil was measured.

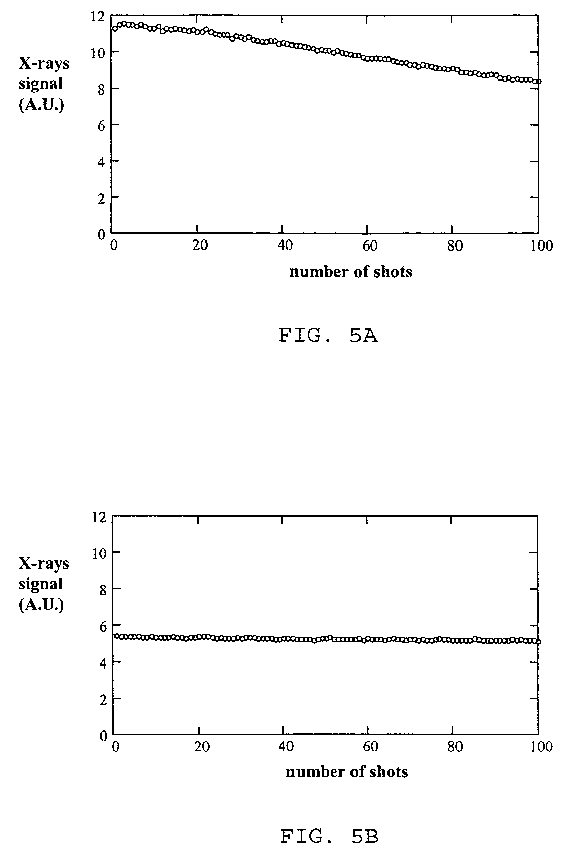

The radiation detector was at 4 cm from the Al-foil, i.e. at 9 cm from the source. As can be seen in Fig. 5A, during the exposition under vacuum to 100 shots of the laser-plasma the transmission of the AL-filter decreases by about 25% corresponding to an average tantalum thickness of 4 nm deposited above the aluminium filter.

The pressure of Kr in the chamber containing the target was then brought to 2.5 mbar. This caused the signal of the detector to decrease immediately by further 34% because of the absorption of krypton (corresponding to a decrease of only 17% at the same distance of 5 cm as that of the aluminium foil) according to the absorption data of Henke shown in Fig. 1. During the following 100 shots (Fig. 5B) the flow of the EUV radiation decreased by only 3% but such decrease was the same as the absorption caused by an increase of 0.03 mbar due to inlet of air during 100 shots (the used cell was not perfectly tight) and then could not be attributed only to deposit of ions.

In conclusion, it is clear from the experimental results that krypton stops the flow of ions and small debris by at least one or more orders of magnitude.

This is obtained for a value of the product pressure-by-distance compatible with a transmission of more than 80% of the EUV radiation between 60 and 90 eV.

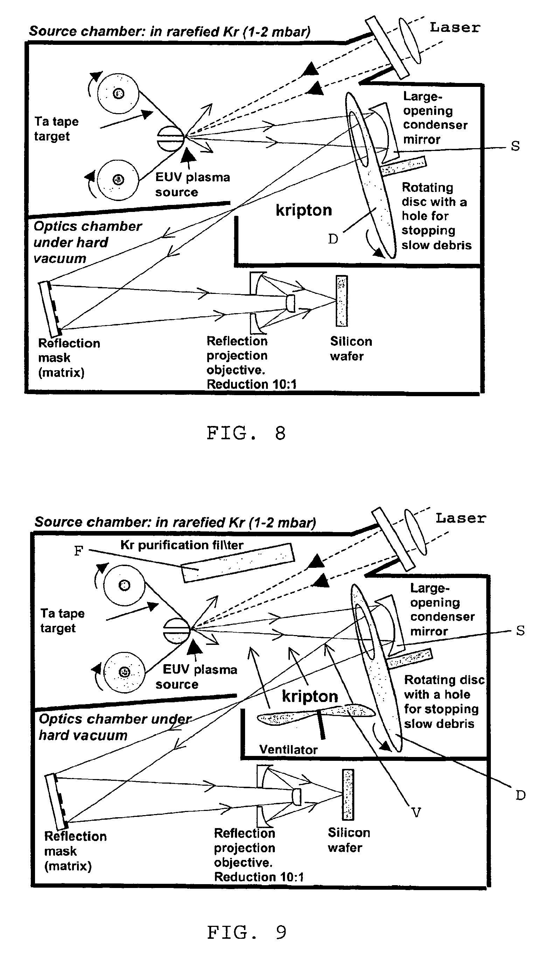

More recent results obtained for a copper target demonstrated that by combining the Kr with two counter-rotating perforated disks (fig. 8) placed at few centimeters from the source, a mitigation factor larger than 2 orders of magnitude is obtained both for the ions and for the debris deposition (with a disks speed of 65 and 75 r.p.s. and a disks diameter and holes diameter of 10 cm and 2.5 cm , respectively.

Therefore, as already mentioned, a feature of the present invention is a method of stopping the flow of ions and small debris in EUV radiation plasma sources wherein krypton or its mixtures is used in the chamber between the EUV plasma source and the first mirror S of the optical projection system, so-called condenser.

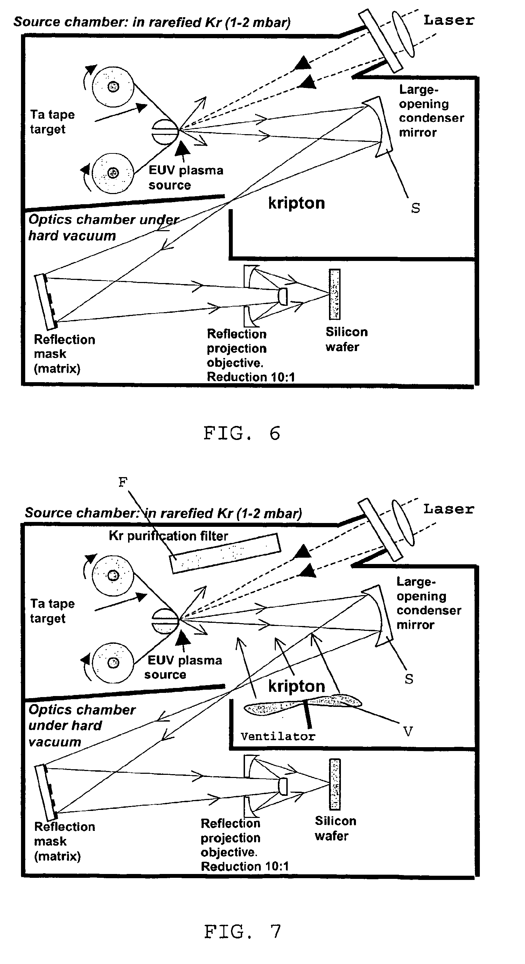

This requires providing a chamber containing the source and the condenser mirror S filled with krypton at low pressure (Fig. 6).

According to the invention shown in Fig. 7, the tested efficiency of krypton (Kr) for filtering ions and small debris emitted by EUV radiation plasma sources is kept constant in time by using krypton or its mixtures in the form of a continuously filtered flow.

This type of application is particularly useful as the accumulation of debris in the atmosphere of krypton within the chamber of the source would reduce more and more the filtration capability and transparency thereof at EUV.

To this purpose, for example, a ventilator V is arranged in the chamber to generate a flow transversal to the direction of the EUV beam and debris. Such ventilator V is placed on one side of the beam, while a filter F to clean the flow of Kr after its crossing through the beam emitted by the plasma source is placed on the other side.

In a variation shown in Fig. 8, not being the claimed invention, there is provided at least one perforated rotating disk (or shutter) D placed crosswise to the direction of the EUV beam and rotating about its symmetry axis synchronically to the emissions of the source in the path between the source and the multilayer mirror S to be "protected". Thus, the radiation hits the mirror through the hole and the larger, then slower, debris (as well as the cloud of krypton rich of metal clusters) stop at the surface of the disk that meanwhile interposes between source and mirror because of its rotation.

Finally, a variation of the invention (Fig. 9) uses a combination of ventilator V and filter F with mechanical devices D so that almost all of debris with large and small size and ions are stopped.

The present invention has been described and illustrated according to a preferred embodiment and some variations thereof, however, it should be understood that anyone who is skilled in the art can make functional and technical equivalent modifications and/or replacements without departing from the scope of the present industrial invention, as defined by the accompanying claims.

## Claims

1. A method of stopping ions and small debris emitted by a plasma generating softx-rays or EUV radiation, whereby an element(s) receives the radiation from the plasma in a way that said element is exposed to debris emitted by the plasma, comprising the step of creating a flow of krypton at low pressure between said plasma and said element to reduce the quantity of debris reaching the element,
**characterized by** the step of
continuously passing the flow of Krypton through a filter (7) in order to keep constant the transparency of the Krypton for EUV radiation and the efficiency of the Krypton to filter small debris and ions emitted by the plasma.

2. The method according to claim 1, wherein the Krypton is rarefied Krypton at the pressure of about 1 mbar.

3. The method according to claim 1, further comprising the step of providing at least one perforated rotatable disk or shutter (D) rotating about its symmetry axis in such a way that each of its holes is positioned on the direction of the EUV beam synchronically to the emissions of the EUV source, which shutter is placed crosswise to the direction of the EUV beam in the path between the source and said element (S) to be protected, thereby obtaining that the radiation hits the mirror through the hole or through the shutter and the larger, then slower, debris and the dirty krypton cloud stop at the surface of the disk that meanwhile interposes between source and mirror because of its rotation.

4. An apparatus for performing the method according to claim 1, comprising a vacuum system, means for generating a plasma in said vacuum system, the plasma generating soft x-rays or EUV radiation, an element(s) inside said vacuum system, the element receiving the radiation from the plasma in a way that the element is exposed to debris emitted by the plasma
**characterized by**
ventilation means (V) for creating a flow of a gas being present in the chamber at low pressure, and a filter (F) for cleaning krypton, arranged such that the ventilation means force the flow of gas to pass through the filter.

5. The apparatus according to claim 4, further comprising at least one perforated rotatable disk or shutter (D) rotating, in operation, about its symmetry axis in such away that each of its holes is positioned on the direction of the EUV beam synchronically to the emissions of the EUV source, which shutter is placed crosswise to the direction of the EUV beam in the path between the source and said element (S) to be protected, thereby obtaining that, in operation, the radiation hits the mirror through the hole or through the shutter and the larger, then slower, debris and the dirty krypton cloud stop at the surface of the disk that meanwhile interposes between source and mirror because of its rotation.

## Patentansprüche

1. Verfahren zum Abstoppen von Ionen und kleinen Fremdkörpern, welche durch eine plasmaerzeugende weiche Röntgenstrahlung oder EUV-Strahlung emittiert werden, wobei ein Element (S) die Strahlung von dem Plasma derart empfängt, dass das Element den durch das Plasma emittierten Fremdkörpern ausgesetzt ist, mit dem Schritt:
Erzeugen eines Kryptonflusses bei niedrigem Druck zwischen dem Plasma und dem Element, um die Menge an Fremdkörpern, welche das Element erreichen, zu reduzieren,
**gekennzeichnet durch** den Schritt:
kontinuierliches Durchlaufen lassen des Kryptonflusses durch einen Filter (F), um die Transparenz des Kryptons für EUV-Strahlung und die Effizienz des Kryptons, Fremdkörper und Ionen, welche **durch** das Plasma emittiert sind, konstant zu halten.

2. Verfahren gemäß Anspruch 1, wobei das Krypton verdünntes Krypton bei einem Druck von etwa 1 mbar ist.

3. Verfahren gemäß Anspruch 1, welches ferner den Schritt umfasst: Bereitstellen von mindestens einer perforierten drehbaren Scheibe oder Blende (D), welche um ihre Symmetrieachse derart rotiert, dass jedes ihrer Löcher in der Richtung des EUV-Strahls synchron mit den Emissionen der EUV-Quelle angeordnet ist, wobei die Blende quer zu der Richtung des EUV-Strahls in dem Weg zwischen der Quelle und dem zu schützenden Element (S) angeordnet wird, wodurch erreicht wird, dass die Strahlung den Spiegel durch das Loch oder durch die Blende trifft und die größeren, dann langsameren Fremdkörper und die schmutzige Kryptonwolke an der Oberfläche der Scheibe, welche zwischenzeitlich aufgrund ihrer Drehung zwischen Quelle und Spiegel liegt, abstoppt.

4. Vorrichtung zur Durchführung des Verfahrens gemäß Anspruch 1 mit einem Vakuumsystem, Mitteln zum Erzeugen eines Plasmas in dem Vakuumsystem, wobei das Plasma weiche Röntgenstrahlung oder EW-Strahlung erzeugt, ein Element (S) innerhalb des Vakuumsystems, wobei das Element die Strahlung von dem Plasma derart empfängt, dass das Element Fremdkörpern ausgesetzt ist, welche durch das Plasma emittiert sind
**gekennzeichnet durch**
Ventilationsmittel (V) zum Erzeugen eines Gasflusses, welcher in der Kammer bei niedrigem Druck vorliegt, und einem Filter (F) zum Reinigen von Krypton, welcher derart eingerichtet ist, dass die Ventilationsmittel den Gasfluss zwingen den Filter zu durchlaufen.

5. Vorrichtung gemäß Anspruch 4, mit ferner mindestens einer perforierten drehbaren Scheibe oder Blende (D), welche im Betrieb um ihre Symmetrieachse derart rotiert, dass jedes ihrer Löcher in der Richtung des EUV-Strahls synchron mit den Emissionen der EUV-Quelle angeordnet ist, wobei die Blende quer zu der Richtung des EUV-Strahls in dem Weg zwischen der Quelle und dem zu schützenden Element (S) angeordnet ist, wodurch erreicht wird, dass im Betrieb die Strahlung den Spiegel durch das Loch oder durch die Blende trifft und die größeren, dann langsameren Fremdkörper und die schmutzige Kryptonwolke an der Oberfläche der Scheibe, welche zwischenzeitlich aufgrund Ihrer Drehung zwischen Quelle und Spiegel liegt, abstoppt.

## Revendications

1. Procédé d'arrêt des ions et des débris de petite taille émis à partir d'un plasma générant des rayons X faibles ou un rayonnement UV extrême, moyennant quoi un élément(s) reçoit le rayonnement provenant du plasma d'une manière telle que ledit élément est exposé aux débris émis par le plasma, comprenant l'étape de création d'un flux de krypton à basse pression entre ledit plasma et ledit élément pour réduire la quantité de débris atteignant l'élément,
**caractérisé par** l'étape de passage en continu du flux de Krypton à travers un filtre (7) afin de maintenir à un niveau constant la transparence du Krypton pour le rayonnement UV extrême et l'efficacité du Krypton pour filtrer des débris de petite taille et des ions émis par le plasma.

2. Procédé selon la revendication 1, dans lequel le Krypton est du Krypton raréfié, à la pression d'environ 1 mbar.

3. Procédé selon la revendication 1, comprenant en outre l'étape de fourniture d'au moins un disque ou obturateur pivotable perforé (D) pivotant autour de son axe de symétrie de telle sorte que chacun de ses orifices est positionné sur la direction du faisceau UV extrême de façon synchrone par rapport aux émissions de la source UV extrême, lequel obturateur est placé transversalement par rapport à la direction du faisceau UV extrême dans le trajet entre la source et ledit élément (S) à protéger, ce qui permet ainsi d'obtenir que le rayonnement frappe le miroir à travers l'orifice ou à travers l'obturateur et le débris de grande taille et donc plus lent, et le nuage sale de krypton s'arrête au niveau de la surface du disque, qui s'interpose au même moment entre la source et le miroir du fait de sa rotation.

4. Appareil de réalisation du procédé selon la revendication 1, comprenant une installation de vide, un moyen de génération d'un plasma dans ladite installation de vide, le plasma générant des rayons X faibles ou un rayonnement UV extrême, un élément(s) à l'intérieur de ladite installation de vide, l'élément recevant le rayonnement provenant du plasma d'une manière telle que l'élément est exposé aux débris émis par le plasma
**caractérisé par**
un moyen de ventilation permettant de créer un flux d'un gaz présent dans la chambre à basse pression, et un filtre permettant de nettoyer le krypton, agencé de telle sorte que le moyen de ventilation pousse le flux de gaz à passer à travers le filtre.

5. Appareil selon la revendication 4, comprenant en outre au moins un disque ou obturateur (D) pivotable perforé pivotant, lors du fonctionnement, autour de son axe de symétrie, de telle sorte que chacun de ses orifices est positionné sur la direction du faisceau UV extrême de façon synchrone par rapport aux émissions de la source UV extrême, lequel obturateur est placé transversalement par rapport à la direction du faisceau UV extrême dans le trajet entre la source et ledit élément (S) à protéger, ce qui permet ainsi d'obtenir que le rayonnement frappe le miroir à travers l'orifice ou à travers l'obturateur et les débris de grande taille et donc plus lent, et le nuage sale de krypton s'arrête au niveau de la surface du disque, qui s'interpose au même moment entre la source et le miroir du fait de sa rotation.
